# EUROPEAN PATENT APPLICATION

(11) **EP 1 895 585 A2**
(43) Date of publication of application: **05.03.2008**
(21) Application number: 07016074.2
(22) Date of filing: 16.08.2007
(51) Int. Cl.: H01L 23/498

(54) **Chip film package and display panel assembly having the same**

(30) Priority: 01.09.2006 KR 20060084286
(71) Applicant: Samsung Electronics Co., Ltd., Yeongtong-gu Suwon-city, Gyeonggi-do 442-742 (KR)
(72) Inventor: Hwang, In-yong, Suwon-si, Gyeonggi-do (KR); Son, Sun-kyu, Suwon-si, Gyeonggi-do (KR)
(74) Representative: Weitzel, Wolfgang

(57) **Abstract**

A chip film package which can achieve a fine pitch and a display panel assembly having the same are provided. The chip film package includes a base film made of an insulating material, a wire pattern formed on the base film to form a predetermined circuit, and a lead which is formed at one end of the wire pattern to be electrically connected to an external terminal, wherein a width (Wb) of the bottom surface of the lead adjacent to the base film is smaller than a width (Wt) of the top surface of the lead connected to the external terminal.

## Description

### BACKGROUND OF THE INVENTION

### FIELD OF THE INVENTION

The present invention relates to a chip film package and a display panel assembly having the same, and more particularly, to a chip film package having a fine pitch between signal wires and a display panel assembly having the same.

### DISCUSSION OF THE BACKGROUND

As electronic products containing semiconductor chips, such as mobile phones, personal digital assistants (PDAs), liquid crystal panels, and notebook computers have become more popular they have become smaller, lighter, more efficient, and higher in density.

Along with such trends in the semiconductor industry, there is widespread use of chip film packages in semiconductor chip mounting technology. A chip film package is constructed such that wiring patterns and leads connected thereto are formed on a film made of an insulating material such as polyimide. The wire patterns can be simultaneously bonded to bumps prefabricated on a semiconductor chip using Tape Automated Bonding (TAB). Due to this feature the chip film package has also become known as TAB tape.

A display panel assembly includes a display panel for displaying image information and a chip film package for driving the display panel. Leads provided on the chip film package are electrically connected to signal wires provided on the display panel. With the progress of high resolution display panels, the pitch between signal wires has gradually decreased.

Therefore, development of chip film packages having a finer pitch is highly desirable.

### SUMMARY OF THE INVENTION

The present invention provides a chip film package having a fine pitch.

The present invention also provides a display panel assembly having a chip film package having a fine pitch.

Additional features of the invention will be set forth in the description which follows, and in part will be apparent from the description, or may be learned by practice of the invention.

The present invention discloses, a chip film package including a base film including an insulating material, a wire pattern arranged on the base film, and a lead arranged at one end of the wire pattern to be connected to a terminal, wherein a width (Wb) of the bottom surface of the lead adjacent to the base film is smaller than a width (Wt) of the top surface of the lead to be connected to the terminal.

The present invention also discloses, a display panel assembly including a display panel including a plurality of connection terminals provided along an edge portion of the display panel to receive driving signals from an external device through the connection terminals and to display image information, a chip film package including a semiconductor chip to drive the display panel, the chip film package being connected to the connection terminals, wherein the chip film package includes a base film including an insulating material, a wire pattern arranged on the base film to form a predetermined circuit, a semiconductor chip connected to the wire pattern, and a lead which is formed at one end of the wire pattern to be connected to the connection terminals, wherein a width (Wb) of the bottom surface of the lead adjacent to the base film is smaller than a width (Wt) of the top surface of the lead to be connected to the connection terminals.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.

FIG. 1 is a perspective view of a display panel assembly according to an exemplary embodiment of the present invention.

FIG. 2 is a perspective view of a data chip film package according to an exemplary embodiment of the present invention.

FIG. 3 is an exploded perspective view illustrating a connection type in which the data chip film package shown in FIG. 2 is electrically connected to a display panel.

FIG. 4 is a cross-sectional view taken along line A-A' of FIG. 3.

FIG. 5 is a perspective view of a gate chip film package according to an exemplary embodiment of the present invention.

FIG. 6 is an exploded perspective view illustrating a connection type in which the gate chip film package shown in FIG. 5 is electrically connected to a display panel.

FIG. 7 is a cross-sectional view taken along line B-B' of FIG. 6.

### DETAILED DESCRIPTION OF THE ILLUSTRATED EMBODIMENTS

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity.

It will be understood that when an element or layer is referred to as being "on", "connected to" or "coupled to" another element or layer, it can be directly on; connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, the present invention will be described in detail with reference to the accompanying drawings.

Examples of display panel assemblies according to exemplary embodiments of the present invention include, but are not limited to, a thin film transistor-liquid crystal display (TFT-LCD), a plasma display panel (PDP), and an organic electroluminescence display device.

An example of a chip film package used in the present invention includes a tape automated bonding (TAB) tape which includes wiring patterns formed on a base film and a semiconductor chip bonded to the wiring patterns by a TAB technique. Examples of the chip film package of the present invention include, but are not limited to, a tape carrier package (TCP), a chip on film (COF), and the like. However, the above-referenced chip film packages are provided for illustration.

In the exemplary embodiments of the present invention that follow, a liquid crystal display is used as an example of a display panel assembly, and a COF is used as an example of a chip film package having panel driver semiconductor chips mounted thereon.

Hereinafter, a chip film package according to an exemplary embodiment of the present invention and a display panel assembly including the chip film package will be described with reference to the accompanying drawings.

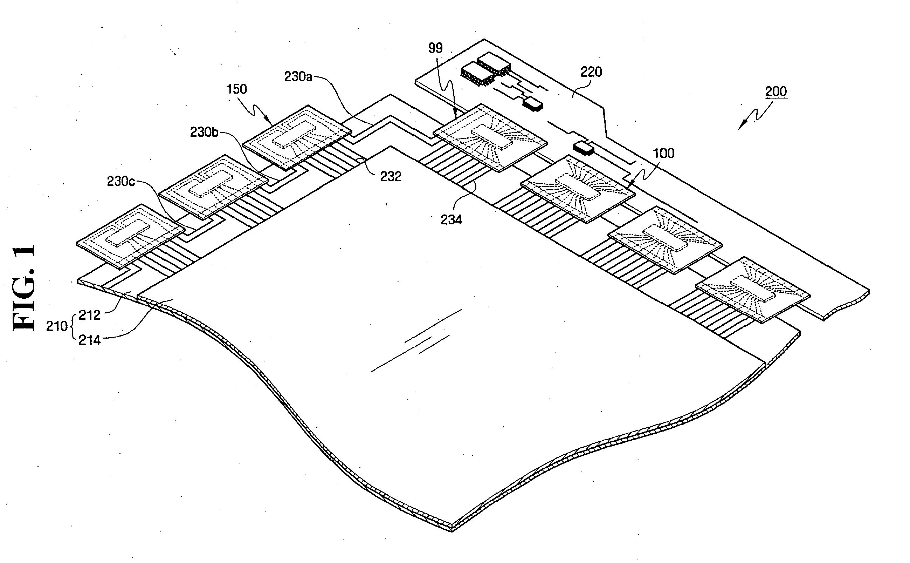

FIG. 1 is a perspective view of a display panel assembly (200) according to an exemplary embodiment of the present invention.

Referring to FIG. 1, the display panel assembly 200 includes a display panel 210, a plurality of gate chip film packages 150, a plurality of data chip film packages 99 and 100, and a printed circuit board (PCB) 220.

The display panel 210 includes a lower substrate 212 and an upper substrate 214. The lower substrate 212 has a plurality of gate lines 232, a plurality of data lines 234, a plurality of thin film transistors (TFTs), and a plurality of pixel electrodes. The upper substrate 214 has black matrixes, color filters, and a common electrode. The upper substrate 214 is smaller than the lower substrate 212, and the upper substrate 214 is disposed adjacent to and facing the lower substrate 212. A liquid crystal layer (not shown) is interposed between the lower substrate 212 and the upper substrate 214.

The gate chip film packages 150 are connected to the gate lines 232, and the data chip film packages 99 and 100 are connected to the data lines 234.

The PCB 220 has a plurality of driver elements mounted thereon. The plurality of driver elements are semiconductor chips designed by a "one-chip technique," so that gate driving signals and data driving signals can be sent simultaneously to the gate chip film packages 150 and the data chip film packages 99 and 100, respectively.

The gate lines 232 are equally spaced from each other in an effective display region where an image is displayed. However, the gate lines 232 form a series of groups in which the gate lines 232 within a group are narrowly spaced from each other in order to connect to a gate semiconductor chip package 150 in a peripheral portion of the lower substrate 212.

Similarly, the data lines 234 are equally spaced from each other in an effective display region where an image is displayed. However, the data lines 234 are narrowly spaced from each other in a peripheral portion of the lower substrate 212 for connection with the data chip film packages 99 and 100.

Each gate chip film package 150 includes wire patterns formed on the base film, and a gate driver semiconductor chip connected to the wire patterns. The gate driver semiconductor chip is connected to the wire patterns by a TAB technique. The gate chip film packages 150 transmit the gate driving signals from the PCB 220 to the TFTs of the lower substrate 212.

The data chip film packages 99 and 100 may include a first data chip film package 99, which provides gate and data driving signals, and a second data chip film package 100, which provides a data driving signal.

The first data chip film package 99 includes wire patterns formed on the base film and a data driver semiconductor chip connected to the wire patterns. The data driver semiconductor chip is connected to the wire patterns by a TAB technique. Some of the wire patterns are not connected to the data driver semiconductor chip. Rather, they are connected to first gate driving signal transmission lines 230a of the lower substrate 212 so that the gate driving signals from the PCB 220 are transmitted to the gate chip film packages 150. The remaining wire patterns are connected to the data driver semiconductor chip and connected to the data lines 234 of the lower substrate 212 so that the data driving signals from the PCB 220 are transmitted to the TFTs of the lower substrate 212.

The second data chip film package 100 disposed adjacent to the first data chip film package 99 includes wire patterns formed on the base film, and a data driver semiconductor chip connected to the wire patterns, like the first data chip film package 99. The data driver semiconductor chip is connected to the wire patterns by a TAB technique. The second data chip film package 100 transmits the data driving signals from the PCB 220 to the TFTs of the lower substrate 212.

The first gate driving signal transmission lines 230a are disposed at an edge area of the lower substrate 212 between the gate chip film package 150 and the adjacent first data chip film package 99. One end of the first gate driving signal transmission lines 230a extends toward the data lines 234 and the other end of the first gate driving signal transmission lines 230a extends toward the gate lines 232.

Second and third gate driving signal transmission lines 230b and 230c are separated from the first gate driving signal transmission lines 230aand are disposed between the respective groups of gate lines 232. The second and third gate driving signal transmission lines 230b and 230c are configured such that they extend from an edge of the lower substrate 212 in parallel to a group of gate lines 232, then extend perpendicular to the gate lines 232, and extend back to the edge of the lower substrate 212 in parallel to another group of gate lines 232.

In the display panel assembly 200 according to an exemplary embodiment of the present invention, signals are supplied from the PCB 220 to the display panel 210 in the following manner.

When image signals from an external information processor, e.g., a main computer device, are sent to the PCB 220, the PCB 220 generates gate and data driving signals corresponding to the image signals.

The data driving signals generated by the PCB 220 are sent to the data driver semiconductor chip via the wire patterns of the data chip film packages 99 and 100 to be processed. Thereafter, the processed data driving signals are sent through wire patterns of the data chip film packages 99 and 100 to the data lines 234 of the lower substrate 212.

Simultaneously, the gate driving signals generated by the PCB 220 are sent to the first gate driving signal transmission lines 230a via some of the wire patterns of the first data chip film package 99.

The gate driving signals sent via the first gate driving signal transmission lines 230a are transmitted to the gate driver semiconductor chip via the wire patterns of the gate chip film package 150 to be processed. Thereafter, the processed gate driving signals are sent through wire patterns of the gate chip film package 150 to the gate lines 232 of the lower substrate 212.

Some of the gate driving signals sent through the first gate driving signal transmission lines 230a are transmitted to an adjacent gate chip film package 150 via the second gate driving signal transmission lines 230b, without being processed by the gate driver semiconductor chip.

If the gate output signals are applied to the gate lines 232 of the lower substrate 212 through the above-described procedure, all TFTs of one row are turned on by the gate output signals. When the TFTs of one row are turned on, data voltages applied to the data driver semiconductor chip are rapidly sent to the pixel electrodes. As a result, an electric field is formed between the pixel electrodes and the common electrode. The formation of the electric field changes the arrangement of liquid crystal molecules interposed between the upper substrate 214 and the lower substrate 212, thereby displaying image information.

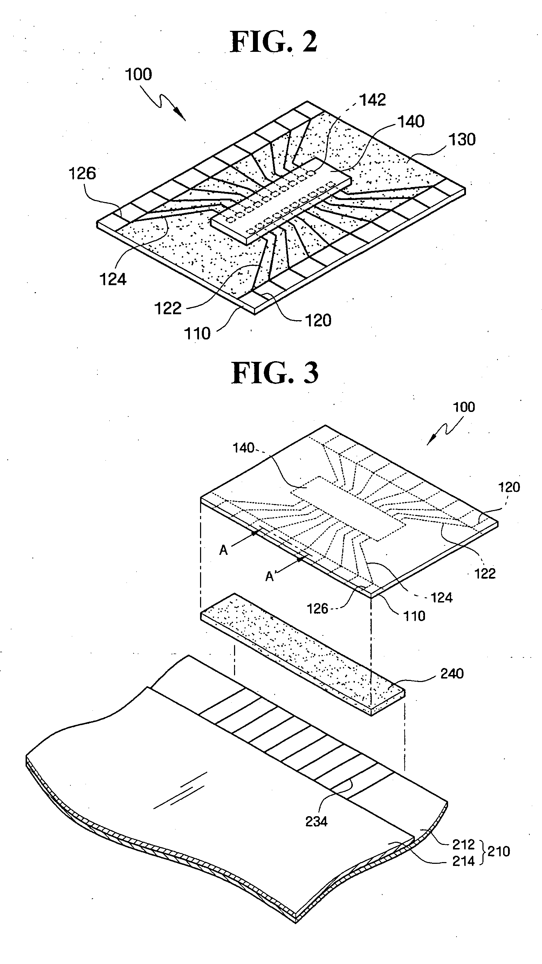

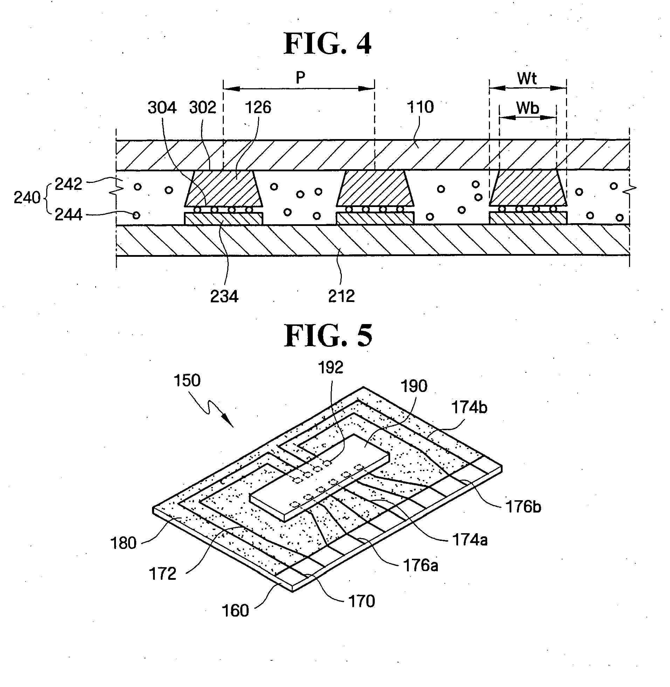

Next, a connection relationship between a data chip film package according to an exemplary embodiment of the present invention and the display panel assembly will be described with reference to FIG. 2, FIG. 3, and 4. FIG. 2 is a perspective view of a data chip film package (100) according to an exemplary embodiment of the present invention, FIG. 3 is an exploded perspective view illustrating a connection type in which the data chip film package shown in FIG. 2 is electrically connected to a display panel, and FIG. 4 is a cross-sectional view taken along line A-A' of FIG. 3. The exemplary embodiments of the present invention that follow will be described with reference to the second data chip film package 100 of the first and second data chip film packages 99 and 100 for convenience of illustration.

The data chip film package 100 includes a base film 110, which may be made of a flexible material, wire patterns formed on one plane of the base film 110, leads formed at one end of the wire patterns and connected to external wires, and a data driver semiconductor chip 140 connected to the wire patterns by a TAB technique.

Here, the base film 110 may be made of an insulating material such as a polyimide resin, a polyester resin, or the like.

The leads include input leads 120 formed at one side of the base film 110 and output leads 126 formed at the other side of the base film 110. The wire patterns include input wire patterns 122 extending substantially linearly from the input leads 120 and connected to the data driver semiconductor chip 140 and output wire patterns 124 extending substantially linearly from the output leads 126 and connected to the data driver semiconductor chip 140. The data driver semiconductor chip 140 is bonded to the input wire patterns 122 and the output wire patterns 124 by a TAB technique using bumps 142.

The wire patterns and the leads may be made of metallic materials, e.g., a copper (Cu) foil. In one exemplary embodiment, such a wiring layer may be a copper (Cu) foil that is plated with tin, gold, nickel, or solder.

Examples of methods of forming such a layer of copper foil, which is one example of the wire patterns, include casting, laminating, electroplating, and the like. In casting, a liquid base film is applied to a rolled copper foil with subsequent thermal curing. In laminating, a rolled copper foil is placed on a base film for subsequent thermal compression. In electroplating, a copper seed layer is deposited on a base film that is then immersed within a copper-containing electrolyte, thereby forming the copper foil when electricity is applied.

Wiring is then made by patterning the copper foil. For example, a photo/etching process may be performed on the copper foil to selectively etch the copper foil for forming wire patterns and leads, thereby forming predetermined circuits. Referring to FIG. 4, if the wire patterns and the leads, e.g., the output leads 126, are over-etched using an anisotropic etchant in the etching process, undercut portions may be formed on the output leads 126. In other words, since the anisotropic etchant tends to preferentially etch a portion of each output lead 126 that is adjacent to the base film 110, a width Wb of its bottom surface 302 adjacent to the base film 110 is smaller than a width Wt of its top surface 304, so that a cross section of the output leads 126 has the shape of a reverse-trapezoid.

In addition, it is preferable that a ratio of the width Wb of the bottom surface 302 to the width Wt of the top surface 304 satisfies an inequality 0.6 ≤ Wb/Wt < 1. In order to reduce a pitch P between leads, the width Wb of the bottom surface 302 should be smaller than the width Wt of the top surface 304, that is, Wb/Wt < 1. When the width Wb of the bottom surface 302 is much smaller than the width Wt of the top surface 304, the lead structure may become unstable. Thus, it is preferable that the inequality Wb/Wt≥0.6 is satisfied.

A portion of the base film 110 onto which the data driver semiconductor chip 140 is mounted is referred to as a "chip mount portion". To protect the wire patterns from adverse environmental conditions, the region of the base film 110 outside of the chip mount portion and the leads is covered with a protective layer 130. The protective layer 130 may be made of solder resist.

A method of connecting the data chip film package 100 to the data lines 234 on the lower substrate 212 employs an anisotropic conductive film (ACF) 240. The ACF 240 is a double-sided tape including an adhesive 242 cured by heat and fine conductive particles 244 mixed with and contained in the adhesive 242. Due to high temperature and pressure that is applied, fine conductive particles 244 are compressed at a contact portion between the data lines 234 of the lower substrate 212 and the output leads 126 of the data chip film package 100. Specifically compression occurs between contact pads formed at ends of the data lines 234 and the output leads 126 of the data chip film package 100 so that the data lines 234 may be connected to the output leads 126 through the conductive particles 244. The adhesive 242 fills irregular surfaces other than the output leads 126 and is cured therein, thereby allowing the lower substrate 212 and the data chip film package 100 to be attached to each other.

As described above, when each of the wire patterns and the leads, e.g., the output leads 126, has a reverse trapezoidal cross-sectional shape, a fine pitch can be achieved while maintaining the stability of connection with the data lines 234. Since the output leads 126 have a cross sectional shape of a reverse-trapezoid, even if the pitch P between the output leads 126 is reduced for the purpose of achieving a fine pitch, a space between each of the bottom surfaces 302 of the output leads 126 can be maintained. When the output leads 126 have the shape of a reverse-trapezoid, the pitch P between the output leads 126 can be reduced to about 25 µm or less, preferably about 20 µm or less.

In addition, since the width Wt of the top surface 304 of the output leads 126 is relatively large, even if the width of the output leads 126 is reduced for the purpose of reducing the size of the data chip film package 100, a sufficiently wide contact area between the output leads 126 and the data lines 234 can be obtained, thereby increasing contact reliability between the output leads 126 and the data lines 234. Furthermore, according to the present invention, high contact reliability between the output leads 126 and the data lines 234 can reduce the risk of cracks, which may be generated at the contact area between the output leads 126 and the data lines 234 when the data chip film package 100 is bent, thereby reducing failures of the data chip film package 100.

Although the present invention has been described using the output leads 126 of the data chip film package 100, it will be understood by those of ordinary skill in the art that features of the invention are not limited to the output leads 126 and can also be applied to other kinds of leads and wire patterns formed on the base film 110, i.e., the input leads 120, the input wire patterns 122, and the output wire patterns 124.

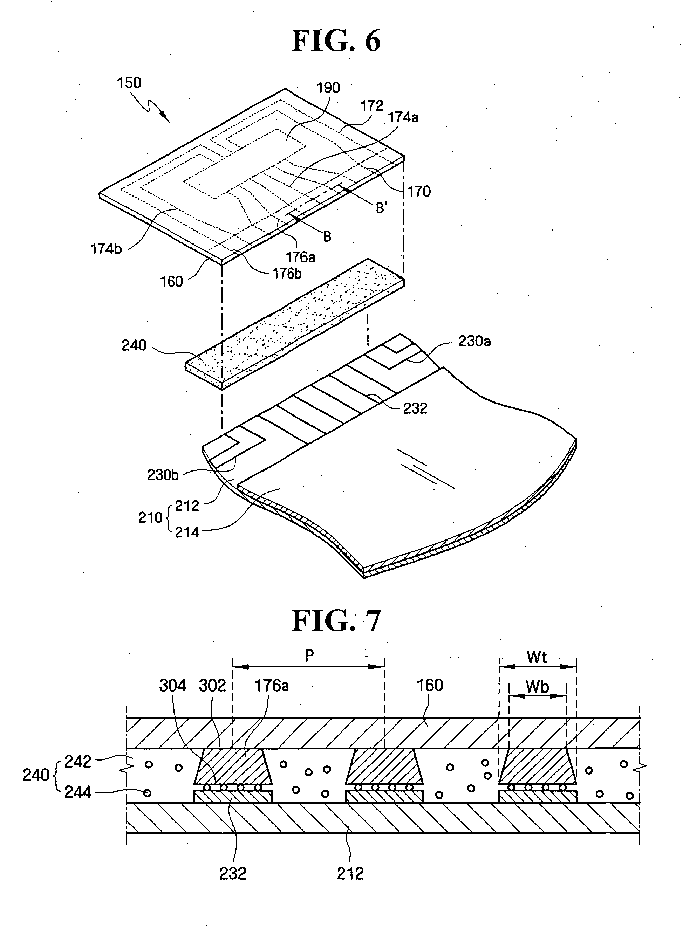

Next, a connection relationship between the chip film package according to an exemplary embodiment of the present invention and the display panel assembly will be described with reference to FIG. 5, FIG. 6, and FIG. 7. FIG. 5 is a perspective view of a gate chip film package according to an exemplary embodiment of the present invention, FIG. 6 is an exploded perspective view illustrating a connection type in which the gate chip film package shown in FIG. 5 is connected to a display panel, and FIG. 7 is a cross-sectional view taken along line B-B' of FIG. 6.

The gate chip film package 150 includes a base film 160, which may be made of a flexible material, wire patterns formed on one plane of the base film 160, leads formed at one end of the wire patterns, and a gate driver semiconductor chip 190 connected to the wire patterns by a TAB technique.

Here, the base film 160 may be made of an insulating material such as a polyimide resin, a polyester resin, or the like.

The leads include input leads 170, and first output leads 176a and second output leads 176b formed at one side of the base film 160. The wire patterns include input wire patterns 172 connecting the input leads 170 to the gate driver semiconductor chip 190, first output wire patterns 174a connecting the gate driver semiconductor chip 190 to the first output leads 176a and second output wire patterns 174b connecting the gate driver semiconductor chip 190 to the second output leads 176b. The gate driver semiconductor chip 190 is bonded to the input wire patterns 172 and the first and second output wire patterns 174a and 174b by a TAB technique using bumps 192.

In detail, the input wire patterns 172 extend from the input leads 170 along the peripheral portion of the base film 160 and are connected to the gate driver semiconductor chip 190. The first output wire patterns 174a extend substantially linearly from the gate driver semiconductor chip 190 and are connected to the first output leads 176a. The second output wire patterns 174b extend from the gate driver semiconductor chip 190 along the peripheral portion of the base film 160 and are connected to the second output leads 176b.

The wire patterns and the leads can be formed by substantially the same method and materials as those used for forming the wire patterns and the leads of the data chip film package 100 shown in FIG. 2.

Accordingly, as shown in FIG. 7, if the wire patterns and the leads, e.g., the first output leads 176a, are over-etched using an anisotropic etchant in the etching process, an undercut portion may be formed under the first output leads 176a. In other words, since the anisotropic etchant tends to etch a portion of each of the first output leads 176a that is adjacent to the base film 160, a width Wb of its bottom surface 302 adjacent to the base film 160 is smaller than a width Wt of its top surface 304, so that a cross section of the first output leads 176a has the shape of a reverse-trapezoid. In addition, as described above with reference to the data driver semiconductor chip 140, it is preferable that a ratio of the width Wb of the bottom surface 302 to the width Wt of the top surface 304 satisfies an inequality 0.6 ≤ Wb/Wt < 1. When the first output leads 176a have the shape of a reverse-trapezoid, the pitch P between the first output leads 176a can be reduced to about 25 µm or less, preferably about 20 µm or less.

A portion of the base film 160 onto which the gate driver semiconductor chip 190 is mounted is referred to as a "chip mount portion". To protect the wire patterns from adverse environmental conditions, the region of the base film 160 outside of the chip mount portion and the leads is covered with a protective layer 180. The protective layer 180 may be made of solder resist.

A method of connecting the gate chip film package 150 to the gate lines 232 on the lower substrate 212 employs an ACF 240. The ACF 240 is a double-sided tape including an adhesive 242 cured by heat and fine conductive particles 244 mixed with and contained in the adhesive 242. Due to high temperature and pressure, the fine conductive particles 244 are compressed at a contact portion between the gate lines 232 of the lower substrate 212 and the first output leads 176a of the gate chip film package 150. Specifically compression occurs between contact pads formed at ends of the gate lines 232 and the first output leads 176a of the gate chip film package 150 so that the gate lines 232 are connected to the first output leads 176a through the conductive particles 244. Also, the input leads 170 of the gate chip film package 150 are connected to the first gate driving signal transmission lines 230a through the conductive particles 244, whereas the second output leads 176b of the gate chip film package 150 are connected to the second gate driving signal transmission lines 230b through the conductive particles 244.

The adhesive 242 fills irregular surfaces other than the first output leads 176a and is cured therein, thereby allowing the lower substrate 212 and the gate chip film package 150 to be attached to each other.

As described above, when each of the wire patterns and the leads provided on the gate chip film package 150, e.g., the first output leads 176a, has a reverse trapezoidal cross-sectional shape, a fine pitch can be achieved while maintaining the stability of connection with the gate lines 232.

Although exemplary embodiments of the present invention have been described using the first output leads 176a of the gate chip film package 150, it will be understood by those of ordinary skill in the art that features of the invention are not limited to the first output leads 176a and can also be applied to other kinds of leads and wire patterns formed on the base film 160, i.e., the input leads 170, the second output leads 176b, the input wire patterns 172, and the first and second output wire patterns 174a and 174b.

As described above, in the chip film package according to exemplary embodiments of the present invention and the display panel including the chip film package, since leads have a cross section having the shape of a reverse-trapezoid, even if a pitch P between the leads is reduced for the purpose of achieving a finer pitch, a space between each of the leads and its bottom surface can be maintained thereby achieving a fine pitch while reducing failures of the chip film package due to short circuits between leads. In addition, since there is a sufficiently wide contact area between leads and data/gate lines, contact reliability between the leads and the data/gate lines is increased. Furthermore, high contact reliability between the leads and the data/gate lines can reduce the risk of cracks.

It will be apparent to those skilled in the art that various modifications and variation can be made in the present invention without departing from the spirit or scope of the invention. Thus, it is intended that the present invention cover the modifications and variations of this invention provided they come within the scope of the appended claims and their equivalents.

## Claims

1. A chip film package, comprising:
a base film comprising an insulating material;
a wire pattern arranged on the base film; and
a lead arranged at one end of the wire pattern to be connected to a terminal, wherein a width (Wb) of the bottom surface of the lead adjacent to the base film is smaller than a width (Wt) of the top surface of the lead to be connected to the terminal.

2. The chip film package of claim 1, wherein a ratio of the width (Wb) to the width (Wt) is 0.6 ≤ Wb/Wt < 1.

3. The chip film package of claim 1, wherein a pitch between two adjacent leads is approximately 25 µm or less.

4. The chip film package of claim 1, wherein the lead has a cross-section having the shape of a reverse-trapezoid.

5. The chip film package of claim 1, further comprising a semiconductor chip connected to the wire pattern.

6. The chip film package of claim 5, wherein the semiconductor chip is a data driver semiconductor chip for processing a data driving signal transmitted to a display panel.

7. The chip film package of claim 6, wherein:
the lead comprises an input lead arranged at a first side of the base film, and an output lead arranged at a second side of the base film;
the wire pattern comprises an input wire pattern extending substantially linearly from the input lead and connected to the semiconductor chip, and an output wire pattern extending substantially linearly from the output lead and connected to the semiconductor chip; and
the wire pattern has a cross-section having the shape of a reverse-trapezoid.

8. The chip film package of claim 5, wherein the semiconductor chip is a gate driver semiconductor chip for processing a gate driving signal transmitted to a display panel.

9. The chip film package of claim 8, wherein:
the lead comprises an input lead, a first output lead, and a second output lead arranged at one side of the base film;
the wire pattern comprises an input wire pattern extending from the input lead along the peripheral portion of the base film and connected to the semiconductor chip, a first output wire pattern extending substantially linearly from the semiconductor chip and connected to the first output lead, and a second output wire pattern extending from the semiconductor chip along the peripheral portion of the base film and connected to the second output lead; and
the wire pattern has a cross-section having the shape of a reverse-trapezoid.

10. A display panel assembly, comprising:
a display panel comprising a plurality of connection terminals provided along an edge portion of the display panel to receive driving signals from an external device through the connection terminals and to display image information;
a chip film package comprising a semiconductor chip to drive the display panel, the chip film package being connected to the connection terminals,
wherein the chip film package comprises:
a base film comprising an insulating material;
a wire pattern arranged on the base film;
a semiconductor chip electrically connected to the wire pattern; and
a lead arranged at one end of the wire pattern to be connected to the connection terminals, wherein a width (Wb) of the bottom surface of the lead adjacent to the base film is smaller than a width (Wt) of the top surface of the lead to be connected to the connection terminals.

11. The display panel assembly of claim 10, wherein a ratio of the width (Wb) to the width (Wt) is 0.6 < Wb/Wt < 1.

12. The display panel assembly of claim 10, wherein a pitch between two adjacent leads is approximately 25 µm or less.

13. The display panel assembly of claim 10, wherein the lead has a cross-section having a shape of a reverse-trapezoid.

14. The display panel assembly of claim 10, wherein the chip film package is connected to the connection terminals using an anisotropic conductive film (ACF).

15. The display panel assembly of claim 10, wherein the semiconductor chip is a data driver semiconductor chip for processing a data driving signal transmitted to the display panel.

16. The display panel assembly of claim 15, wherein:
the lead comprises an input lead arranged at a first side of the base film, and an output lead arranged at a second side of the base film;
the wire pattern comprises an input wire pattern extending substantially linearly from the input lead and connected to the semiconductor chip, and an output wire pattern extending substantially linearly from the output lead and connected to the semiconductor chip; and
the wire pattern has a cross-section having the shape of a reverse-trapezoid.

17. The display panel assembly of claim 10, wherein the semiconductor chip is a gate driver semiconductor chip for processing a gate driving signal transmitted to the display panel.

18. The display panel assembly of claim 17, wherein:
the lead comprises an input lead, a first output lead, and a second output lead arranged at one side of the base film;
the wire pattern comprises an input wire pattern extending from the input lead along the peripheral portion of the base film and connected to the semiconductor chip, a first output wire pattern extending substantially linearly from the semiconductor chip and connected to the first output lead, and a second output wire pattern extending from the semiconductor chip along the peripheral portion of the base film and connected to the second output lead; and
the wire pattern has a cross-section having the shape of a reverse-trapezoid.
